# EUROPÄISCHE PATENTSCHRIFT

(11) **EP 2 313 918 B1**
(45) Veröffentlichungstag und Bekanntmachung des Hinweises auf die Patenterteilung: **04.04.2012**
(21) Anmeldenummer: 09781574.0
(22) Anmeldetag: 06.08.2009
(51) Int. Cl.: H01L 21/677, H01L 21/683, H01L 21/67

(54) **VERFAHREN UND VORRICHTUNG ZUM THERMISCHEN BEARBEITEN VON MOLDWAFERN**
METHOD AND APPARATUS FOR THERMALLY PROCESSING MOULD WAFERS
PROCÉDÉ ET DISPOSITIF DE TRAITEMENT THERMIQUE DE GALETTES MOULÉES

(30) Priorität: 13.08.2008 DE 102008041250
(43) Veröffentlichungstag der Anmeldung: 27.04.2011
(73) Patentinhaber: ERS electronic GmbH, 82110 Germering (DE)
(72) Erfinder: REITINGER, Erich, 82275 Emmering (DE)
(74) Vertreter: Barth, Stephan Manuel
(86) Internationale Anmeldenummer: PCT/EP2009/060230
(87) Internationale Veröffentlichungsnummer: WO 2010/018125

(56) Entgegenhaltungen:
- EP-A- 1 523 030
- WO-A-01/43168
- GB-A- 2 133 757
- US-A- 5 796 486
- US-A1- 2005 167 404
- US-A1- 2007 160 947
- US-A1- 2008 047 950

## Beschreibung

Die vorliegende Erfindung betrifft ein Verfahren und eine Vorrichtung zum thermischen Bearbeiten von Moldwafem, welche auch als gemoldete Wafer, künstliche Wafer bzw. Epoxiwafer bezeichnet werden und welche hierin durchgängig als Moldwafer bezeichnet werden.

Aus der US 2007/160947 A1 ist ein Verfahren zum thermischen Bearbeiten von Siliziumwafern bekannt. Dort werden Wafer von einer Heizeinrichtung zu einer Kühleinrichtung transportiert. In der Heizreinrichtung und der Kühleinrichtung sind Gasauslaufsöffhungen vorgesehen, aus denen Gas ausströmt, um den auf der Heizeinrichtung aufliegenden Siliziumwafer über ein Gaskissen zu der Kühleinrichtung zu bringen.

Die U.S. 4,659,400 A offenbart einen Annealprozess für Halbleiterwafer, um mikroskopische Defekte in der kristallinen Struktur zu beseitigen.

In jüngerer Zeit werden in der Halbleitertechnik immer häufiger sogenannte Moldwafer verwendet, bei denen individuelle Siliziumchips in einer Moldmasse voneinander beabstandet eingebettet sind, wobei die Moldmasse selbst Wafergestalt aufweist und wobei die Siliziumchips z.B. an einer Oberfläche der Moldmasse eingesetzt sind.

Im Rahmen der Herstellung von Moldwafern ist eine thermische Bearbeitung eines Verbundes des Moldwafers, einer thermisch lösbaren Folie und eines dadurch am Moldwafer befestigten Trägersubstrats, z.B. Trägersubstrats, notwendig. Zur Entfernung des Trägersubstrats und der Folie durch durch Auflösen des Verbindungsklebers wird bei dieser thermischen Bearbeitung der Moldwafer von einer Seite her mittels einer Aufspanneinrichtung (Chuck) beheizt und anschließend abgekühlt, was nachstehend näher erläutert wird.

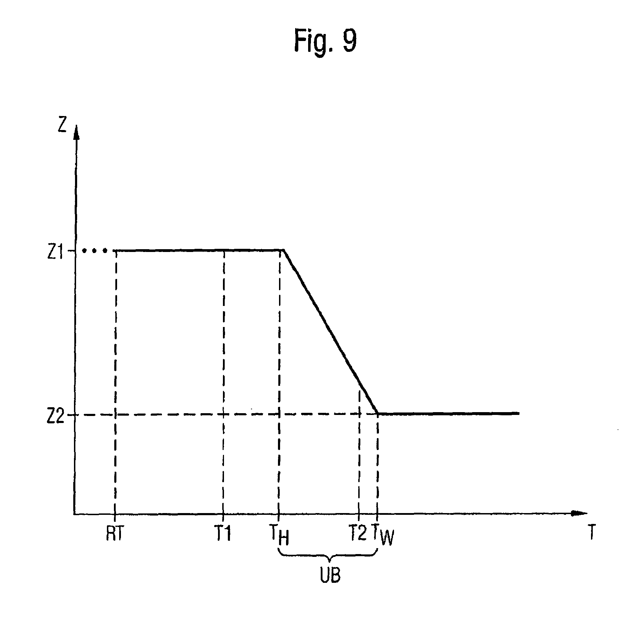

Fig. 9 zeigt eine beispielhafte Abhängigkeit der Zugfestigkeit Z einer Kunststoff-Moldmasse eines Moldwafers von der Temperatur T.

In Fig. 9 bezeichnet Bezugszeichen RT die Raumtemperatur, z.B. 20 °C, T_{H} eine Erhärtungstemperatur, Teine Erweichungstemperatur, UB einen Hart-Weich-Übergangsbereich, T1 eine Vorwärmtemperatur zwischen Raumtemperatur RT und Erhärtungstemperatur T_{H} und T2 eine Temperatur oberhalb der Erhärtungstemperatur T_{H} und unterhalb der Erweichungstemperatur T_{W}. Beispielsweise sind T_{H} = 140 °C, T1 = 110 °C, T2 = 180 °C und T_{W} = 190°C.

Zum Ablösen erfolgen beispielsweise ein Vorwärmen auf T1, ein weiteres Erwärmen auf T2, ein Ablösen bei T2 und ein Abkühlen auf RT. Aufgrund der schlechten Wärmeleitfähigkeit von dem für den Moldwafer verwendeten Kunststoff und der Wechselwirkung mit den eingebetteten Si-Chips mit unterschiedlichem Wärmeausdehnungskoeffizienten führt dieses Abkühlen im Übergangsbereich UB jedoch zu eingefrorenen Spannungen, die in einer Verbiegung (warp) des Moldwafers resultiert, was eine spätere Handhabung und Prozessierung des Moldwafers erschwert bzw. unmöglich macht.

Es ist Aufgabe der vorliegenden Erfindung, ein Verfahren und eine Vorrichtung zum thermischen Bearbeiten von Kunststoffscheiben, insbesondere Moldwafem, anzugeben, welche eine thermische Bearbeitung von Moldwafern, ermöglichen, bei der es zu einer reduzierten bzw. keiner Verbiegung bzw. einer kontrollierbaren gezielten Verbiegung nach dem thermischen Bearbeiten kommt.

Das erfindungsgemäße Verfahren mit den Merkmalen des Anspruchs 1 bzw. die entsprechende Vorrichtung nach Anspruch 12 weisen den Vorteil auf, dass sie ein thermisches Bearbeiten von dünnen Kunststoffscheiben ermöglichen, bei dem es keine Probleme mit Verbiegungen (warp) gibt.

Die einer vorliegenden ersten Erfindung zugrundeliegende Idee besteht darin, dass ein im wesentlichen berührungsloses Transportieren der erwärmten Kunststoffscheibe von der ersten Aufspanneinrichtung zu der zweiten Aufspanneinrichtung, z.B. über ein Luftkissen, durchgeführt wird, um einen thermischen Austausch weitgehend zu vermeiden. Es erfolgt dann eine kontrollierte Bearbeitung beim Abkühlen, so dass keine unkontrollierbaren Verbiegungen auftreten können.

In den Unteransprüchen finden sich vorteilhafte Weiterbildungen und Verbesserungen des betreffenden Gegenstandes der Erfindung.

Gemäß einer bevorzugten Weiterbildung wird das berührungslose Transportieren der erwärmten Kunststoffscheibe mittels einer Gaskissen-Transporteinrichtung durchgeführt. Gemäß einer weiteren bevorzugten Weiterbildung bilden die erste Aufspanneinrichtung, die zweite Aufspanneinrichtung und die Gaskissen-Transporteinrichtung eine gemeinsame ebene Oberfläche.

Gemäß einer weiteren bevorzugten Weiterbildung wird das berührungslose Transportieren der erwärmten Kunststoffscheibe mittels einer Bernoulli-Aufspanneinrichtung durchgeführt.

Gemäß einer weiteren bevorzugten Weiterbildung weist die erste Aufspanneinrichtung in Transportrichtung gerichtete Blasdüsen auf, durch die das Transportieren eingeleitet wird.

Gemäß einer weiteren bevorzugten Weiterbildung werden die erste Aufspanneinrichtung, die zweite Aufspanneinrichtung und die Gaskissen-Transporteinrichtung gemeinsam in Transportrichtung gekippt, um das Transportieren einzuleiten.

Gemäß einer weiteren bevorzugten Weiterbildung ist die Kunststoffscheibe ein Moldwafer, der bei der ersten Temperatur über eine thermisch lösbare Folie mit einem Trägersubstrat verbunden ist, wobei das Trägersubstrat und die thermisch lösbare Folie bei der zweiten Temperatur vom Moldwafer entfernt werden.

Gemäß einer weiteren bevorzugten Weiterbildung wird die Kunststoffscheibe mittels einer dritten Aufspanneinrichtung auf die erste Aufspanneinrichtung gesetzt, wobei das Entfernen des Trägersubstrats durch Abheben nach einem thermischen Lösen der Folie bei der zweiten Temperatur mittels der dritten Aufspanneinrichtung durchgeführt wird.

Gemäß einer weiteren bevorzugten Weiterbildung wird das Aufspannen auf der ersten Aufspanneinrichtung und/oder der zweiten Aufspanneinrichtung durch Ansaugen über Vakuumdüsen durchgeführt wird.

Gemäß einer weiteren bevorzugten Weiterbildung wird das Erreichen einer vorgegebenen Endlage der Kunststoffscheibe auf der zweiten Aufspanneinrichtung durch eine Sensoreinrichtung erfasst, wobei das Aufspannen der erwärmten Kunststoffscheibe auf der zweiten Aufspanneinrichtung durch ein entsprechendes Ausgangssignal der Sensoreinrichtung ausgelöst wird.

Gemäß einer weiteren bevorzugten Weiterbildung ist die Kunststoffscheibe mit einer Transportplatte verbunden, wobei die Kunststoffscheibe über die Transportplatte auf der ersten Aufspanneinrichtung und der zweiten Aufspanneinrichtung aufgespannt wird und die Kunststoffscheibe über die Transportplatte von der ersten Aufspanneinrichtung zu der zweiten Aufspanneinrichtung transportiert wird.

Gemäß einer weiteren bevorzugten Weiterbildung weist die Sensoreinrichtung einen berührungslosen optischen Sensor auf.

Ausführungsbeispiele der Erfindung sind in den Zeichnungen dargestellt und in der nachfolgenden Beschreibung näher erläutert.

Es zeigen:
- Fig. 1a,b: schematische Darstellungen einer Vorrichtung zum thermischen Delaminieren von Moldwafern als erste Ausführungsform der Erfindung, und zwar Fig. 1a in einer Seitenansicht und Fig. 1b in einer Oberseiten-Draufsicht;
- Fig. 2: ein Fliessdiagramm zum Erläutern eines Verfahrens zum thermischen Delaminieren von Moldwafern mittels der Vorrichtung gemäß Fig. 1 als zweite Ausführungsform der Erfindung;
- Fig. 3: eine schematische Seitenansicht einer Vorrichtung zum thermischen Delaminieren von Moldwafern als dritte Ausführungsform der Erfindung;
- Fig. 4: eine zweite Aufspanneinrichtung zur Verwendung bei einer vierten Ausführungsform der Erfindung;
- Fig. 5: eine erste Aufspanneinrichtung zur Verwendung bei einer fünften Ausführungsform der Erfindung;
- Fig. 6: eine schematische Seitenansicht einer Vorrichtung zum thermischen Delaminieren von Moldwafern als sechste Ausführungsform der Erfindung;
- Fig. 7: eine schematische Seitenansicht einer Vorrichtung zum thermischen Delaminieren von Moldwafern als siebente Ausführungsform der Erfindung;
- Fig. 8: eine schematische Seitenansicht einer Vorrichtung zum thermischen Delaminieren von Moldwafern als achte Ausführungsform der Erfindung; und
- Fig. 9: eine beispielhafte Abhängigkeit der Zugfestigkeit Z einer Kunststoff-Moldmasse eines Moldwafers von der Temperatur T.

In den Figuren bezeichnen gleiche Bezugszeichen gleiche oder funktionsgleiche Bestandteile.

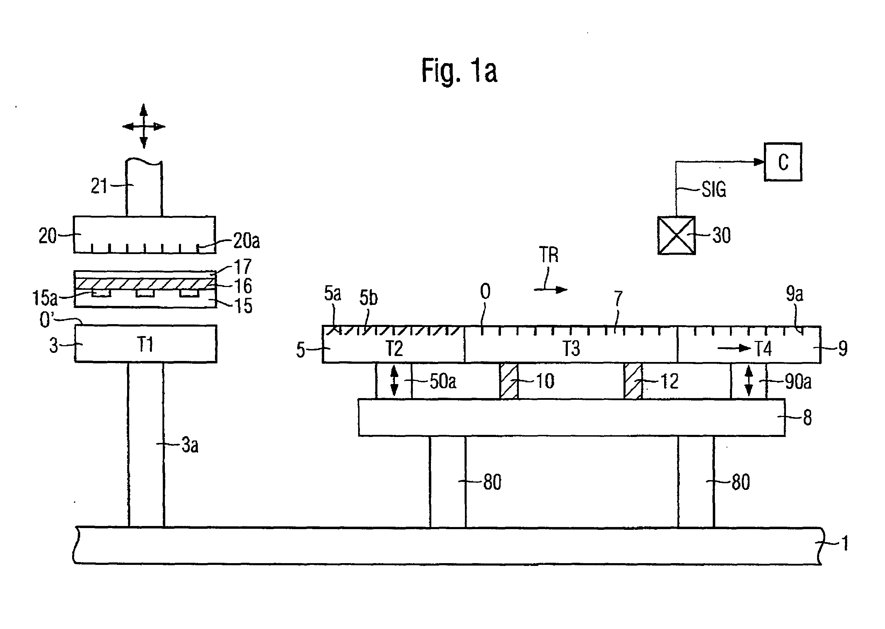

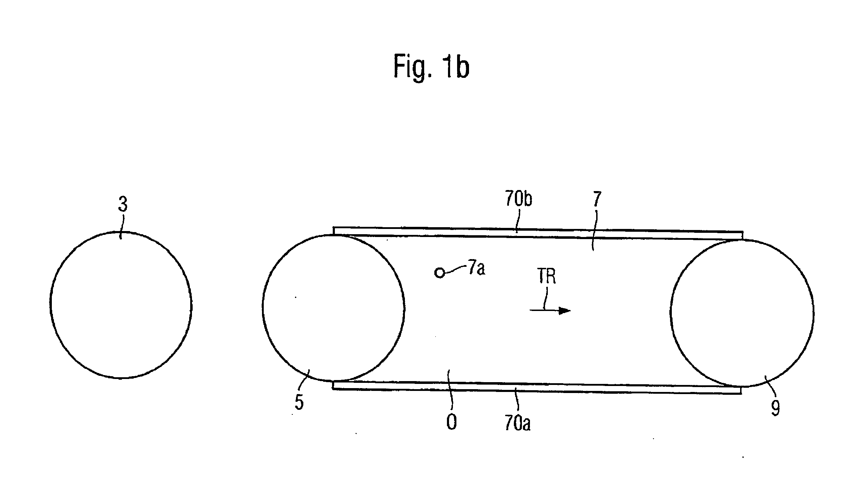

Fig. 1a,b zeigen schematische Darstellungen einer Vorrichtung zum thermischen Delaminieren von Moldwafern als erste Ausführungsform der Erfindung, und zwar Fig. 1a in einer Seitenansicht und Fig. 1b in einer Oberseiten-Draufsicht.

In Figur 1a, b bezeichnet Bezugszeichen 1 eine Unterlage-Plattform, welche beispielsweise aus Aluminium gefertigt ist. Über einen Standfuß 3a ist eine Vorlageplattform 3 mit einer oberen Oberfläche O' auf der Plattform 1 angebracht. Die Vorlageplattform 3 ist beheizbar und weist beim vorliegenden Beispiel die Temperatur T1 = 110° Celsius entsprechend dem Beispiel von Fig. 9 auf. Bezugszeichen 15 bezeichnet einen Moldwafer, in den nach einem bekannten Verfahren Siliziumchips 15a eingebettet sind, deren eine Oberfläche bündig mit einer Oberseite des Moldwafers 15 ist. Über eine thermisch lösbare Folie 16 ist ein Trägersubstrat 17, z.B. aus Stahl, mit dem Moldwafer verbunden, was vom Herstellungsprozess des Moldwafers herrührt, bei dem die Siliziumchips 15a auf die thermisch lösbare Folie 16 gesetzt werden und anschließend der Verguss mit Kunststoffmasse zum Bilden des Moldwafers 15 in einer entsprechenden Form erfolgt.

Bezugszeichen 20 bezeichnet eine Aufspanneinrichtung (Chuck), welche Vakuumdüsen 20a zum Aufspannen des Moldwafers 15 im Verbund mit der thermisch lösbaren Folie und dem Trägersubstrat 17 aufweist, Die Aufspanneirichtung 20 ist über einen Roboterann 21 dreidimensional verfahrbar.

Weiterhin vorgesehen in der Vorrichtung gemäß Figur 1a, b ist eine beheizbare Aufspannvorrichtung 5, welche auf einem Standfuß 50a angebracht ist, der höhenverstellbar ist. Der Standfuß 50a ist auf einer Querstrebe 8 angebracht, die wiederum über Standfüsse 80 auf der Unterlage-Plattform 1 ruht.

Die Aufspanneinrichtung 5 befindet sich bei der Temperatur T2 entsprechend dem Beispiel von Fig. 9, welche bei 180° Celsius liegt und sowohl oberhalb der Erhärtungstemperatur T_{H} = 140 °C des Kunststoffs des Moldwafers 15 als auch in etwa bei oder über der Zersetzungstemperatur eines Klebers der thermisch lösbaren Folie 16 liegt.

Bezugszeichen 5a bezeichnet Vakuumdüsen der Aufspanneinrichtung 5, und Bezugszeichen 5b bezeichnet in eine Transportrichtung TR gerichtete Blasdüsen der Aufspanneinrichtung 5, welche später näher erläutert werden.

Unmittelbar angrenzend an die Aufspanneinrichtung 5 und eine gemeinsame ebene Oberfläche O bildend sind eine Luftkissen-Transporteinrichtung 7 und eine weitere kühlbare Aufspanneinrichtung 9. Die Luftkissen-Transporteinrichtung 7 besitzt Blasdüsen 7a, welche dazu geeignet sind, unter dem Moldwafer 15 ein Luftkissen mit einer Temperatur von T3 = 180°C zum berührungslosen Transport von der Aufspanneinrichtung 5 zur Aufspanneinrichtung 9 zu bilden.

Die kühlbare Aufspanneinrichtung 9 weist ebenfalls Vakuumdüsen 9a auf und ist auf eine Temperatur T4 = 20° Celsius geregelt (Raumtemperatur RT entsprechend dem Beispiel von Fig. 9), auf die der Moldwafer 15 am Ende der Prozesssequenz, welche nachstehend beschrieben wird, abzukühlen ist. Der Standfuß 90a der Aufspanneinrichtung 9 ist ebenfalls höhenverstellbar.

Auf der thermisch isolierenden Standfüßen 10, 12 ist die Luftkissen-Transporteinrichtung 7 auf der Querstrebe 8 angebracht. Eine derartige Konstruktion ermöglicht es, den Einfluss unterschiedlicher thermischer Ausdehnungen der Einrichtungen 5, 7, 9 leicht ausgleichen bzw. eliminieren zu können. Das heißt, die Einrichtungen 5 und 9 können unabhängig voneinander höhenverstellt werden, um ein Einjustieren der gemeinsamen ebenen Oberfläche O zu ermöglichen.

Wie aus Figur 1b erkennbar, sind an den Seiten der Luftkissen-Transporteinrichtung 7 Seitenführungen 70a, 70b angebracht, welche vermeiden sollen, dass ein darauf berührungslos transportierter Moldwafer 15 seitlich abrutscht.

Da die Seitenkanten des Moldwafers 15 im Vergleich zu seiner unteren bzw. oberen Oberfläche verschwindend gering sind, beeinflusst eine derartige Führung ein berührungsloses Transportieren des Moldwafers 15 aufgrund des von den Blasdüsen 7a der Luftkissen-Transporteinrichtung 7 erzeugten Heissluftkissens nicht. Aus Gründen der Übersichtlichkeit ist in Fig. 1b nur eine Blasdüse 7a eingezeichnet.

Schließlich bezeichnet Bezugszeichen 30 in Figur 1a einen optischen Sensor, welcher ein Signal SIG an eine Steuereinrichtung C sendet, welche die gesamte Anlage, insbesondere den Transport des Moldwafers 15 und die thermischen Schritte auf den Aufspanneinrichtungen 5, 9 steuert. Die Sensoreinrichtung 30 erfasst im vorliegenden Fall optisch, ob der von der Aufspanneinrichtung 5 über die Luftkissen-Transporteinrichtung 7 zur Aufspanneinrichtung 9 beförderte Moldwafer 15 vollständig in seiner Endlage auf der Aufspanneinrichtung 9 aufliegt, worauf ansprechend die Ansaugung über die Vakuumdüsen 9a der Aufspanneinrichtung 9 initiiert wird.

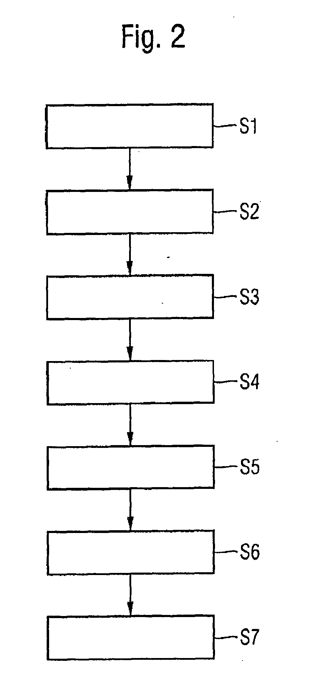

Fig. 2 ist ein Fliessdiagramm zum Erläutern eines Verfahrens zum thermischen Delaminieren von Moldwafern mittels der Vorrichtung gemäß Fig. 1 als zweite Ausführungsform der Erfindung.

Dabei wird angenommen, dass der Kunststoff des Moldwafers 15 die in Fig. 9 gezeigte beispielhafte Temperaturabhängigkeit der Zugfestigkeit aufweist.

In Schritt S1 wird ein Moldwafer 15 in Verbund mit der thermisch lösbaren Folie 16 und dem Trägersubstrat 17 von der Aufspanneinrichtung 20 aus einer (nicht dargestellten) Kassette geholt und derart auf die Vorlageplattform 3 gesetzt, dass der Moldwafer 15 ihre obere Oberfläche O' kontaktiert. Im Schritt S2 erfolgt ein Vorwärmen des Moldwafers 15 auf die Temperatur T1 =110° Celsius.

Im sich daran anschließenden Schritt S3 hebt die Aufspanneinrichtung 20 den Moldwafer im Verbund mit der thermisch lösbaren Folie 16 und dem Trägersubstrat 17 im vorgewärmten Zustand mit circa 110° Celsius von der Vorlageplattform 3 ab und transportiert ihn auf die heizbare Aufspanneinrichtung 5, welche eine Temperatur T2 = 180° Celsius aufweist. Der im Verbund befindliche Moldwafer 15 wird anschließend über die Vakuumdüsen 5a der Aufspanneinrichtung 5 auf dieser aufgespannt. Gleichzeitig wird die Aufspanneinrichtung 20 ebenfalls auf 180° Celsius erwärmt.

Sobald der Kleber der thermisch lösbaren Folie 16 seine Spalttemperatur von 180° Celsius erreicht hat, wird die Aufspanneinrichtung 20 nach oben verfahren und somit das Trägersubstrat 17 vom Moldwafer entfernt, was im Schritt S4 geschieht.

Im Schritt S5 wird die thermisch lösbare Folie 16 mittels einer geeigneten (nicht gezeigten) Vorrichtung von der oberen Oberfläche des Moldwafers 15 entfernt.

Im darauffolgenden Schritt S6 wird das Ansaugen des Moldwafers 15, welcher auf der Aufspanneinrichtung 5 liegt, unterbrochen, und ein Druckimpuls wird auf die Blasdüsen 5b gegeben, so dass der Moldwafer 15 einen Anfangsbewegungsimpuls in Transportrichtung TR erfährt. Der Moldwafer 15 gleitet darauf über das Luftkissen der Luftkissen-Transporteinrichtung 7 berührungslos zur Aufspanneinrichtung 9, wobei er bis zum Erreichen der Aufspanneinrichtung 9 im Wesentlichen keine thermische Energie verliert, da der Luftstrom der Luftkissen-Transporteinrichtung 7, der auf die Temperatur T3 = 180° Celsius vorgewärmt ist, etwaige Wärmeverluste verhindert.

Erfasst die Sensoreinrichtung 30 am Ende von Schritt S6, dass sich der Moldwafer 15 vollständig auf der Aufspanneinrichtung 9 befindet, so wird dort automatisch ein Ansaugen über die Vakuumdüsen 9a initiiert, so dass der Moldwafer 15 fest auf der Aufspanneinrichtung 9 aufgespannt ist.

Daran anschließend erfolgt im Schritt S7 ein Abkühlen des Moldwafers 15 von der Temperatur T2 = 180° Celsius auf die Temperatur T4 = 20° Celsius. Aufgrund des kontrollierten Abkühlprozesses im aufgespannten Zustand kann eine Verbiegung des Moldwafers 15 bei dieser thermischen Bearbeitung im Übergangsbereich UB entsprechend dem Beispiel von Fig. 9 vermieden werden.

Nach vollständigem Abkühlen des Moldwafers 15 auf der Aufspanneinrichtung 9 wird dieser durch die Aufspanneinrichtung 20 in eine (nicht dargestellte) Kassette transportiert, wobei die Aufspanneinrichtung 20 zwischenzeitlich bereits einen folgenden Moldwafer 15 im Verbund auf die Vorlageplattform 3 gesetzt hat, um somit Zeit zu sparen.

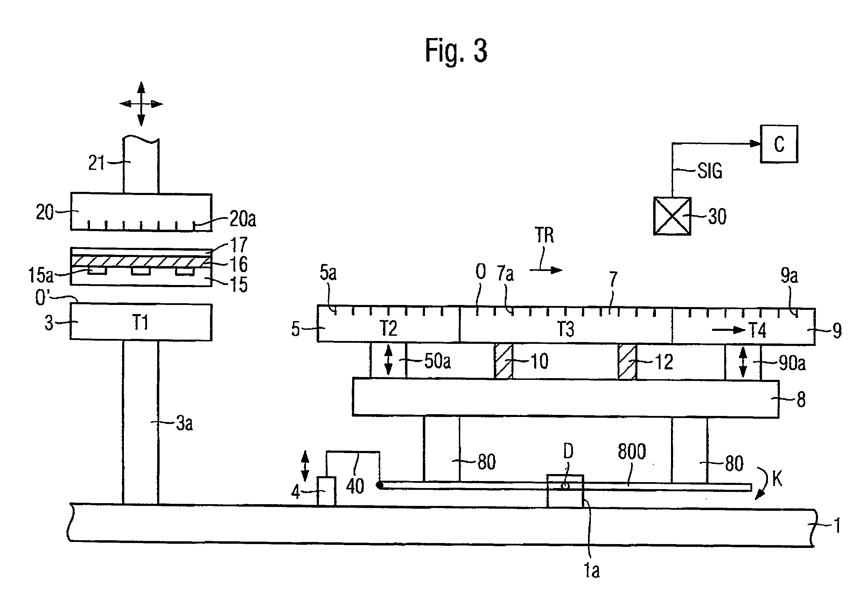

Fig. 3 zeigt eine schematische Seitenansicht einer Vorrichtung zum thermischen Delaminieren von Moldwafern als dritte Ausführungsform der Erfindung.

Bei der dritten Ausführungsform gemäß Figur 3 weist die beheizbare Aufspanneinrichtung 5 keine gerichteten Blasdüsen 5b auf, sondern lediglich Vakuumdüsen 5a. Zum Initiieren des Transports des Moldwafers 15 von der Aufspanneinrichtung 5 zur Aufspanneinrichtung 9 über die Luftkissen-Transporteinrichtung 7 ist der Verbund aus Aufspanneinrichtung 5, Luftkissen-Transporteinrichtung 7 und Aufspanneinrichtung 9 um eine Drehachse D in Transportrichtung kippbar, was durch einen Pfeil K angedeutet ist. Zu diesem Zweck ist eine weitere Strebe 800 vorgesehen, welche um die Drehachse D drehbar ist, wobei die Drehachse an einem Ständer 1a auf der Unterlage-Plattform 1 angebracht ist. Die Standfüsse 80 der Querstrebe 8 ruhen in diesem Beispiel auf der weiteren Strebe 800.

Über die Steuereinrichtung C steuerbar ist die Kippbewegung durch einen linearen Aktuator 4, der über eine Schubstange 40 mit der weiteren Strebe 800 verbunden ist.

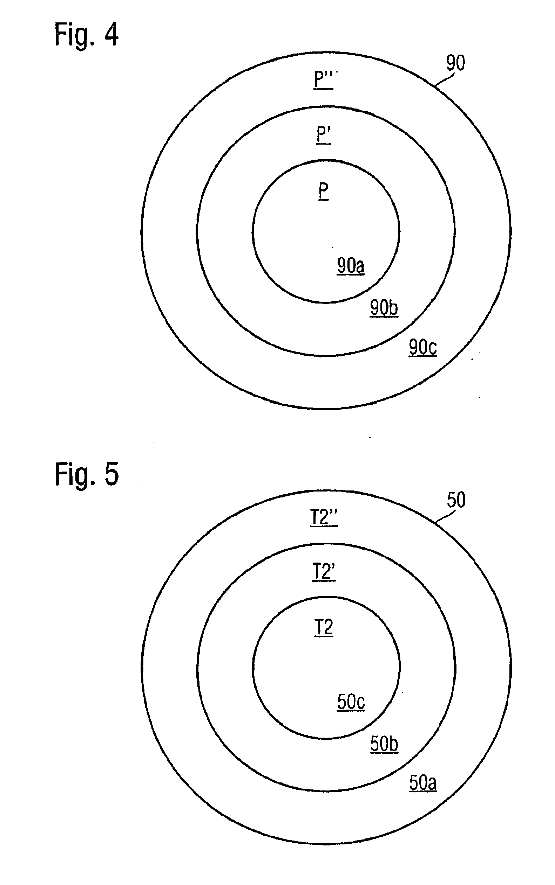

Fig. 4 zeigt eine zweite Aufspanneinrichtung zur Verwendung bei einer vierten Ausführungsform der Erfindung.

Die bei der vierten Ausführungsform verwendete kühlbare Aufspanneinrichtung 90 (entsprechend der Aufspanneinrichtung 9 bei der ersten bis dritten Ausführungsform) weist verschiedene Ansaugkreise 90a, 90b und 90c auf, an denen unabhängig voneinander Drucke P, P', P" angelegt werden können. Dies hat den Vorteil, dass im Falle einer geringfügigen Verbiegung des Moldwafers nach dem Transport über die Luftkissen-Transporteinrichtung 7 das Ansaugen und Aufspannen durch die Aufspanneinrichtung 90 derart gestaltet werden kann, dass dieser geringfügigen Verbiegung beim Erstarren entgegengewirkt wird.

Fig. 5 zeigt eine erste Aufspanneinrichtung zur Verwendung bei einer fünften Ausführungsform der Erfindung.

Bei der fünften Ausführungsform hat die Aufspanneinrichtung 50 (entsprechend der Aufspanneinrichtung 5 bei der ersten bis vierten Ausführungsform) drei verschiedene Heizkreise, welche die Bereiche 50a, 50b und 50c mit entsprechenden Temperaturen T2, T2', T2" beheizen. Auch diese zonenförmige Beheizung kann dazu genützt werden, geringfügige Verbiegungen, welche beim Moldwafer 15 vorliegen, beim Abkühlen auszugleichen.

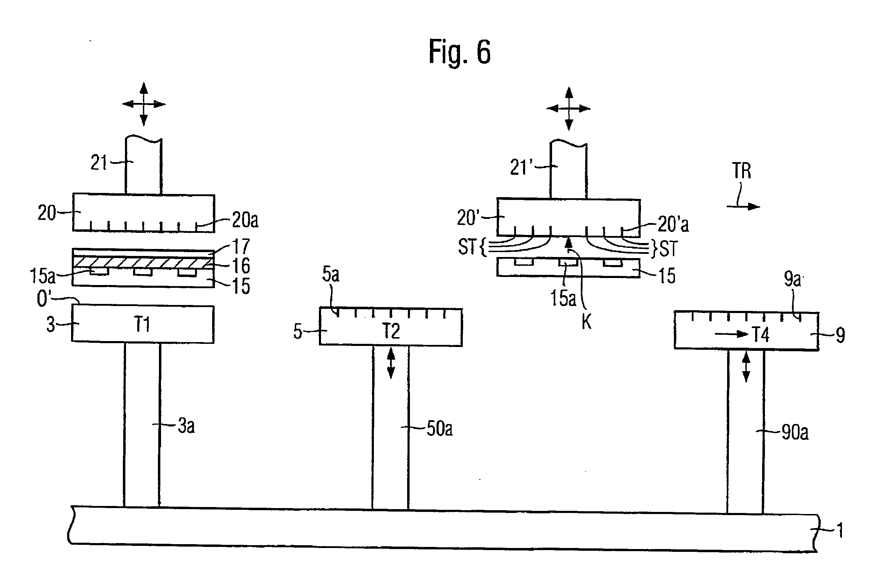

Fig. 6 zeigt eine schematische Seitenansicht einer Vorrichtung zum thermischen Delaminieren von Moldwafern als sechste Ausführungsform der Erfindung.

Bei der sechsten Ausführungsform gemäß Figur 6 ist zum im wesentlichen berührungslosen Transportieren des erwärmten Moldwafers 15 von der beheizbaren Aufspannungseinrichtung 5 zur kühlbaren Aufspanneinrichtung 9 keine Luftkissen-Transporteinrichtung 7 vorgesehen, sondern eine Bernoulli-Aufspanneirichtung 20', welche an einem Roboterarm 21' befestigt ist, der dreidimensional bewegbar ist. Die Bernoulli-Aufspanneinrichtung 20' weist Blasdüsen 20a' auf, durch die eine nach außen gerichtete auf 180 °C temperierte Strömung ST zwischen dem Moldwafer 15 und ihrer Oberfläche erzeugbar ist. Durch die nach außen gerichtete Strömung kommt es im mittleren Bereich zu einer anziehenden Kraft K, was bewirkt, dass der Moldwafer 15 berührungslos durch die Bernoulli-Aufspanneinrichtung 20' transportiert werden kann.

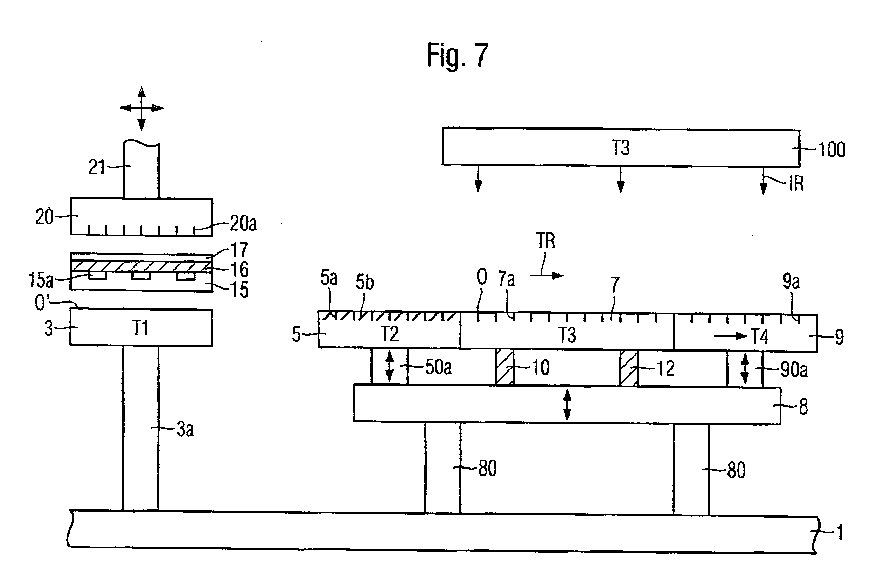

Fig. 7 zeigt eine schematische Seitenansicht einer Vorrichtung zum thermischen Delaminieren von Moldwafern als siebente Ausführungsform der Erfindung.

Bei der siebenten Ausführungsform gemäß Figur 7 ist zur Gewährleistung eines wärmeverlustfreien Transports des Moldwafers 15 von der Aufspanneinrichtung 5 zur Endposition auf der Aufspanneinrichtung 9 eine zusätzliche Infrarot-Heizeinrichtung 100 bei einer Temperatur T3 = 180° Celsius oberhalb der Luftkissen-Transporteinrichtung 7 und der Aufspanneinrichtung 9 vorgesehen. Sobald der Kühlvorgang auf der Aufspanneinrichtung 9 beginnt, wird die Infrarotbestrahlung durch die Infrarot-Heizeinrichtung 100 prozessgesteuert abgeschaltet bzw. abgerampt.

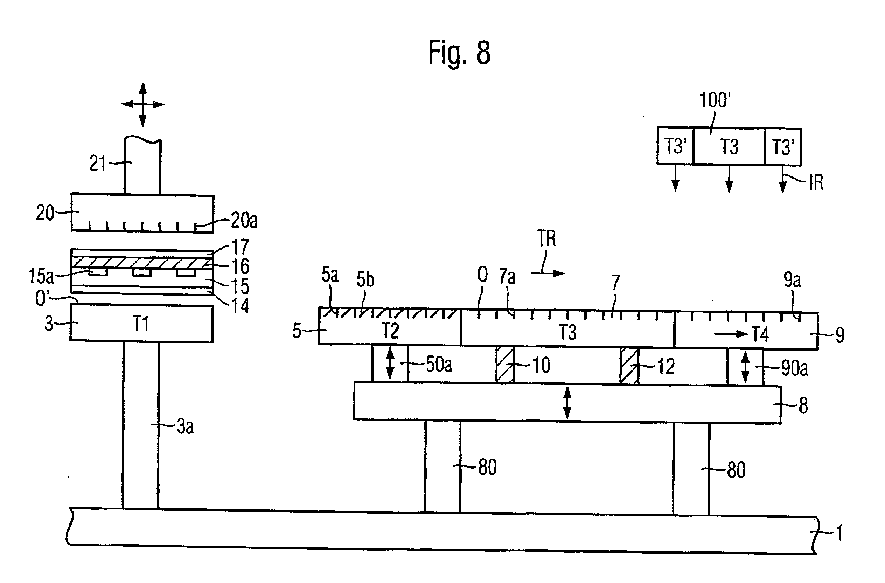

Fig. 8 zeigt eine schematische Seitenansicht einer Vorrichtung zum thermischen Delaminieren von Moldwafern als achte Ausführungsform der Erfindung.

Bei der achten Ausführungsform gemäß Figur 8 ist eine Infrarot-Heizeinrichtung 100' lediglich oberhalb der Aufspanneinrichtung 9 vorgesehen, welche getrennte Bestrahlungsbereiche aufweist, die Temperaturen T3 = 180° Celsius bzw. T3' = 185° Celsius entsprechen. Durch eine derartige Bestrahlung der Oberseite des Moldwafers 15 welche in unterschiedliche Kreisringrcgionen unterteilt ist, lässt sich ebenfalls ein Ausgleich einer möglicherweise vorhandenen geringfügigen Verbiegung ausgleichen.

Weiterhin ist bei der Ausführungsform gemäß Figur 8 unterhalb des Moldwafers 15 auf seiner den Aufspanneinrichtungen 5, 9 zugewandten Seite eine Transportplatte 14 vorgesehen, beispielsweise in Form einer weitem dünnen Metallplatte, was insbesondere bei dünnen Moldwafern vorteilhaft ist. In diesem Fall erfolgt das Aufspannen auf der Aufspanneinrichtung 5 bzw. 9 über die Transportplatte 14 und auch der Transport von der Aufspanneinrichtung 5 zur Aufspanneinrichtung 9 durch die Luftkissen-Transporteinrichtung über die Transportplatte 14, wonach ein Abkühlen auf der Transportplatte 14 erfolgt..

Obwohl die vorliegende Erfindung vorstehend anhand bevorzugter Ausführungsbeispiele beschrieben wurde, ist sie darauf nicht beschränkt, sondern auf vielfältige Weise modifizierbar.

Obwohl die vorliegende Erfindung vorstehend anhand von Moldwafern erläutern wird, ist die Erfindung nicht darauf beschränkt, sondern generell auf dünne Kunststoffscheiben anwendbar, welche typischerweise eine Dicke zwischen 50 µm und 3 mm und einen Durchmesser zwischen 100 mm und 500 mm aufweisen. Insbesondere ist die Erfindung auch nicht auf runde Geometrien der Kunststoffscheibe begrenzt, sondern für beliebige Geometrien anwendbar. Auch können die Kunststoffscheiben homogen oder inhomogen aufgebaut sein.

Obwohl bei den obigen Ausführungsformen entweder eine Gaskissen-Transporteinrichtung bzw. eine Bernoulli-Aufspanneinrichtung verwendet wurde, ist selbstverständlich jede berührungslose Transporteinrichtung zur Verwendung bei der Erfindung geeignet. Ein weiteres Beispiel für eine derartige berührungslose Transporteinrichtung ist eine Ultraschall-Transporteinrichtung. Maßgeblich ist lediglich, dass ein im wesentlichen berührungsloser Transport ohne nennenswerten Wärmeverlust des Moldwafers bzw. der Kunststoffscheibe erreicht werden kann.

Obwohl in den obigen Beispielen eine spezielle Temperaturabhängigkeit beschrieben wurde, ist die Erfindung nicht darauf beschränkt, sondern für Kunststoffscheiben mit beliebiger Temperaturabhängigkeit der Zugfestigkeit anwendbar.

Obwohl die obigen Ausführungsformen darauf abzielten, die Verbiegung der Moldwafer weitestgehend zu vermeiden, kann die Erfindung auch dazu verwendet werden, prozessgesteuert eine gezielte Verbiegung, z.B. im Bereich einiger Grad, zu bewirken.

Selbstverständlich sind die Merkmale sämtlicher Ausführungsformen auch miteinander kombinierbar.

In den obigen Ausführungsformen wurde eine Kette zweier Aufspanneinrichtungen beschrieben. Es ist ebenfalls möglich, dass eine solche Kette mehr als zwei Aufspanneinrichtungen mit weiteren Zwischentemperaturen aufweist.

## Patentansprüche

1. Verfahren zum thermischen Bearbeiten von Moldwafern (15) mit den Schritten:
Aufspannen eines bei einer ersten Temperatur (T1) befindlichen Moldwafers (15) auf einer ersten Aufspanneinrichtung (5; 50), wobei die erste Temperatur (T1) unterhalb der Erhärtungstemperatur (T_{H}) des Kunststoffs des Moldwafers (15) liegt;
Erwärmen des auf der ersten Aufspanneinrichtung (5; 50) aufgespannten Moldwafers (15), auf eine zweite Temperatur (T2), welche höher als die erste Temperatur (T1) ist und welche oberhalb der Erhärtungstemperatur (T_{H}) liegt;
Beenden des Aufspannens auf der ersten Aufspanneinrichtung (5; 50) und im Wesentlichen berührungsloses Transportieren des auf die zweite Temperatur (T2) erwärmten Moldwafers (15) von der ersten Aufspanneinrichtung (5; 50) zu einer zweiten Aufspanneinrichtung (9; 90);
Aufspannen des erwärmten Moldwafers (15) auf der zweiten Aufspanneinrichtung (9; 90);
Abkühlen des auf der zweiten Aufspanneinrichtung (9; 90) aufgespannten Moldwafers (15) auf eine dritte Temperatur (T4), welche niedriger als die zweite Temperatur (T2) ist und welche unterhalb der Erhärtungstemperatur (T_{H}) liegt; und
Beenden des Aufspannens auf der zweiten Aufspanneinrichtung (9; 90).

2. Verfahren nach Anspruch 1, wobei das berührungslose Transportieren des erwärmten Moldwafers (15) mittels einer Gaskissen-Transporteinrichtung (7) durchgeführt wird.

3. Verfahren nach Anspruch 2, wobei die erste Aufspanneinrichtung (5; 50), die zweite Aufspanneinrichtung (9; 90) und die Gaskissen-Transporteinrichtung (7) eine gemeinsame ebene Oberfläche (O) bilden.

4. Verfahren nach Anspruch 1, wobei das berührungslose Transportieren des erwärmten Moldwafers (15) mittels einer Bernoulli-Aufspanneinrichtung (20') durchgeführt wird.

5. Verfahren nach einem der Ansprüche 1 bis 3, wobei die erste Aufspanneinrichtung (5; 50) in Transportrichtung (TR) gerichtete Blasdüsen (5b) aufweist, durch die das Transportieren eingeleitet wird.

6. Verfahren nach Anspruch 2, wobei die erste Aufspanneinrichtung (5; 50), die zweite Aufspanneinrichtung (9; 90) und die Gaskissen-Transporteinrichtung (7) gemeinsam in Transportrichtung (TR) gekippt werden, um das Transportieren einzuleiten.

7. Verfahren nach einem der vorhergehenden Ansprüche, wobei der Moldwafer (15) bei der ersten Temperatur (T1) über eine thermisch lösbare Folie (16) mit einem Trägersubstrat (17) verbunden ist, und wobei das Trägersubstrat (17) und die thermisch lösbare Folie (16) bei der zweiten Temperatur (T2) vom Moldwafer (15) entfernt werden.

8. Verfahren nach Anspruch 7, wobei der Moldwafer (15) mittels einer dritten Aufspanneinrichtung (20) auf die erste Aufspanneinrichtung (5; 50) gesetzt wird und das Entfernen des Trägersubstrats (17) durch Abheben nach einem thermischen Lösen der Folie (16) bei der zweiten Temperatur (T2) mittels der dritten Aufspanneinrichtung (20) durchgeführt wird.

9. Verfahren nach einem der vorhergehenden Ansprüche, wobei das Aufspannen auf der ersten Aufspanneinrichtung (5; 50) und/oder der zweiten Aufspanneinrichtung (9; 90) durch Ansaugen über Vakuumdüsen (5a; 9a) durchgeführt wird.

10. Verfahren nach einem der vorhergehenden Ansprüche, wobei das Erreichen einer vorgegebenen Endlage des Moldwafers (15) auf der zweiten Aufspanneinrichtung (9; 90) durch eine Sensoreinrichtung (30) erfasst wird und das Aufspannen des erwärmten Moldwafers (15) auf der zweiten Aufspanneinrichtung (9; 90) durch ein entsprechendes Ausgangssignal (SIG) der Sensoreinrichtung (30) ausgelöst wird.

11. Verfahren nach einem der vorhergehenden Ansprüche, wobei der Moldwafer (15) mit einer Transportplatte (14) verbunden ist und der Moldwafer (15) über die Transportplatte (14) auf der ersten Aufspanneinrichtung (5; 50) und der zweiten Aufspanneinrichtung (9; 90) aufgespannt wird und der Moldwafer (15) über die Transportplatte (14) von der ersten Aufspanneinrichtung (5; 50) zu der zweiten Aufspanneinrichtung (9; 90) transportiert wird.

12. Vorrichtung zum thermischen Bearbeiten von Moldwafern (15) mit:
einer heizbaren ersten Aufspanneinrichtung (5; 50), welche dazu ausgelegt ist, einen bei einer ersten Temperatur (T1) befindlichen Moldwafer (15) aufzuspannen, wobei die erste Temperatur (T1) unterhalb der Erhärtungstemperatur des Kunststoffs des Moldwafers (15) liegt, und welche dazu ausgelegt ist, zum Erwärmen des aufgespannten Moldwafers (15) auf eine zweite Temperatur (T2), welche oberhalb der Erhärtungstemperatur (T_{H}) liegt, erwärmt zu werden;
einer kühlbaren zweiten Aufspanneinrichtung (9; 90), welche dazu ausgelegt ist, den erwärmten Moldwafers (15) aufzuspannen, und welche dazu ausgelegt ist, zum Abkühlen des aufgespannten Moldwafers (15) auf eine dritte Temperatur (T4), welche niedriger als die zweite Temperatur (T2) ist und welche unterhalb der Erhärtungstemperatur (T_{H}) liegt, gebracht zu werden;
einer Transporteinrichtung (7; 20'), welche dazu ausgelegt ist, den erwärmten Moldwafer (15) berührungslos von der ersten Aufspanneinrichtung (5; 50) zur zweiten Aufspanneinrichtung (9; 90) zu transportieren.

13. Vorrichtung nach Anspruch 12, wobei die Transporteinrichtung (7; 20) eine Gaskissen-Transporteinrichtung (7) aufweist.

14. Vorrichtung nach Anspruch 13, wobei die erste Aufspanneinrichtung (5; 50), die zweite Aufspanneinrichtung (9; 90) und die Gaskissen-Transporteinrichtung (7) eine gemeinsame ebene Oberfläche (O) bilden.

15. Vorrichtung nach Anspruch 12, wobei die Transporteinrichtung (7; 20) eine Bernoulli-Aufspanneinrichtung (20') aufweist.

16. Vorrichtung nach einem der Ansprüche 12 bis 14, wobei die erste Aufspanneinrichtung (5; 50) in Transportrichtung (TR) gerichtete Blasdüsen (5b) aufweist.

17. Vorrichtung nach Anspruch 14, wobei die erste Aufspanneinrichtung (5; 50), die zweite Aufspanneinrichtung (9; 90) und die Gaskissen-Transporteinrichtung (7) gemeinsam in Transportrichtung (TR) kippbar sind, um das Transportieren einzuleiten.

18. Vorrichtung nach einem der Ansprüche 12 bis 17, wobei die erste Aufspanneinrichtung (5; 50) und/oder die zweite Aufspanneinrichtung (9; 90) Vakuumdüsen (5a; 9a) zum Ansaugen des Moldwafers (15) aufweisen.

19. Vorrichtung nach einem der Ansprüche 12 bis 18, wobei eine Sensoreinrichtung (30) zum Erfassen des Erreichens einer vorgegebenen Endlage des Moldwafers (15) auf der zweiten Aufspanneinrichtung (9; 90) und zum Ausgeben eines entsprechenden Ausgangssignals (SIG) zum Starten des Aufspannens der zweiten Aufspanneinrichtung (9; 90) vorgesehen ist.

20. Vorrichtung nach einem der Ansprüche 12 bis 19, wobei der Moldwafer (15) mit einer Transportplatte (14) verbunden ist und der Moldwafer (15) über die Transportplatte (14) auf der ersten Aufspanneinrichtung (5; 50) und der zweiten Aufspanneinrichtung (9; 90) aufspannbar ist und der Moldwafer (15) über die Transportplatte (14) von der ersten Aufspanneinrichtung (5; 50) zu der zweiten Aufspanneinrichtung (9; 90) transportierbar ist.

21. Vorrichtung nach Anspruch 19, wobei die Sensoreinrichtung (30) einen berührungslosen optischen Sensor aufweist.

22. Vorrichtung nach einem der Ansprüche 12 - 21, wobei eine Infrarot-Heizeinrichtung (100) oberhalb der Transporteinrichtung (7; 20') und der zweiten Aufspanneinrichtung (9; 90) vorgesehen ist, deren Temperatur (T3) bei der zweiten Temperatur (T2) liegt.

23. Vorrichtung nach Anspruch 13, wobei die Gaskissen-Transportvorrichtung (7) derart gestaltet ist, dass sie einen Gasstrom bei der zweiten Temperatur (T2) für den Moldwafer (15) bereitstellen kann.

24. Vorrichtung nach einem der Ansprüche 12 - 23, wobei eine dritte Aufspanneinrichtung (20) zum Setzen des Moldwafers (15) auf die erste Aufspanneinrichtung (5; 50) vorgesehen ist, welche auf die zweite Temperatur (T2) erwärmbar ist.

25. Vorrichtung nach einem der Ansprüche 12 bis 24, wobei die erste Aufspanneinrichtung (5; 50) einen Heizkreis umfasst, welcher dazu ausgelegt ist, die erste Aufspanneinrichtung (5; 50) auf die zweite Temperatur (T2) zu erwärmen.

## Claims

1. Method for thermally processing mould wafers (15) with the steps of:
clamping a mould wafer (15) at a first temperature (T1) on a first clamping device (5; 50), the first temperature (T1) being below the hardening temperature (T_{H}) of the plastic of the mould wafer (15);
heating the mould wafer (15) clamped on the first clamping device (5; 50) to a second temperature (T2), which is higher than the first temperature (T1) and is above the hardening temperature (T_{H});
ending the clamping on the first clamping device (5; 50) and transporting the mould wafer (15) heated to the second temperature (T2) from the first clamping device (5; 50) to a second clamping device (9; 90) substantially contactlessly;
clamping the heated mould wafer (15) on the second clamping device (9; 90);
cooling the mould wafer (15) clamped on the second clamping device (9; 90) down to a third temperature (T4), which is lower than the second temperature (T2) and is below the hardening temperature (T_{H}); and
ending the clamping on the second clamping device (9; 90).

2. Method according to Claim 1, the contactless transportation of the heated mould wafer (15) being carried out by means of a gas-cushion transporting device (7).

3. Method according to Claim 2, the first clamping device (5; 50), the second clamping device (9; 90) and the gas-cushion transporting device (7) forming a common planar surface (0).

4. Method according to Claim 1, the contactless transportation of the heated mould wafer (15) being carried out by means of a Bernoulli clamping device (20').

5. Mould according to one of Claims 1 to 3, the first clamping device (5; 50) having blasting nozzles (5b) directed in the transporting direction (TR), by which the transportation is initiated.

6. Method according to Claim 2, the first clamping device (5; 50), the second clamping device (9; 90) and the gas-cushion transporting device (7) being together tilted in the transporting direction (TR), in order to initiate the transportation.

7. Method according to one of the preceding claims, the mould wafer (15) being bonded to a carrier substrate (17) at the first temperature (T1) by means of a thermally detachable film (16), and the carrier substrate (17) and the thermally detachable film (16) being removed from the mould wafer (15) at the second temperature (T2).

8. Method according to Claim 7, the mould wafer (15) being placed onto the first clamping device (5; 50) by means of a third clamping device (20) and the removal of the carrier substrate (17) being carried out by lifting off by means of the third clamping device (20) after thermal detachment of the film (16) at the second temperature (T2).

9. Method according to one of the preceding claims, the clamping on the first clamping device (5; 50) and/or the second clamping device (9; 90) being carried out by suction attachment by means of vacuum nozzles (5a; 9a).

10. Method according to one of the preceding claims, the reaching of a predetermined end position of the mould wafer (15) on the second clamping device (9; 90) being sensed by a sensor device (30) and the clamping of the heated mould wafer (15) on the second clamping device (9; 90) being triggered by a corresponding output signal (SIG) of the sensor device (30).

11. Method according to one of the preceding claims, the mould wafer (15) being connected to a transport plate (14) and the mould wafer (15) being clamped on the first clamping device (5; 50) and the second clamping device (9; 90) by means of the transport plate (14) and the mould wafer (15) being transported from the first clamping device (5; 50) to the second clamping device (9; 90) by means of the transport plate (14).

12. Apparatus for thermally processing mould wafers (15) with:
a heatable first clamping device (5; 50) arranged to clamp a mould wafer (15) at a first temperature (T1), the first temperature (T1) being below the hardening temperature of the plastic of the mould wafer (15), and to heat the clamped mould wafer (15) to a second temperature (T2), which is above the hardening temperature (T_{H});
a coolable second clamping device (9; 90) arranged toclamp the heated mould wafer (15) and to cool the clamped mould wafer (15) down to a third temperature (T4), which is lower than the second temperature (T2) and is below the hardening temperature (T_{H});
a transporting device (7; 20') arranged to contactlessly transport of the heated mould wafer (15) from the first clamping device (5; 50) to the second clamping device (9; 90).

13. Apparatus according to Claim 12, the transporting device (7; 20) having a gas-cushion transporting device (7).

14. Apparatus according to Claim 13, the first clamping device (5; 50), the second clamping device (9; 90) and the gas-cushion transporting device (7) forming a common planar surface (0).

15. Apparatus according to Claim 12, the transporting device (7; 20) having a Bernoulli clamping device (20').

16. Apparatus according to one of Claims 12 to 14, the first clamping device (5; 50) having blasting nozzles (5b) directed in the transporting direction (TR).

17. Apparatus according to Claim 14, the first clamping device (5; 50), the second clamping device (9; 90) and the gas-cushion transporting device (7) being able to be tilted together in the transporting direction (TR), in order to initiate the transportation.

18. Apparatus according to one of Claims 12 to 17, the first clamping device (5; 50) and/or the second clamping device (9; 90) having vacuum nozzles (5a; 9a) for the suction attachment of the mould wafer (15).

19. Apparatus according to one of Claims 12 to 18, a sensor device (30) being provided for sensing the reaching of a predetermined end position of the mould wafer (15) on the second clamping device (9; 90) and for issuing a corresponding output signal (SIG) for starting the clamping of the second clamping device (9; 90).

20. Apparatus according to one of Claims 12 to 19, the mould wafer (15) being connected to a transport plate (14) and the mould wafer (15) being able to be clamped on the first clamping device (5; 50) and the second clamping device (9; 90) by means of the transport plate (14) and the mould wafer (15) being able to be transported from the first clamping device (5; 50) into the second clamping device (9; 90) by means of the transport plate (14).

21. Apparatus according to Claim 19, the sensor device (30) having a contactless optical sensor.

22. Apparatus according to one of Claims 12 - 21, an infrared heating device (100) of which the temperature (T3) is above the second temperature (T2) being provided above the transporting device (7; 20') and the second clamping device (9; 90).

23. Apparatus according to Claim 13, the gas-cushion transporting device (7) being arranged in such a way that it can provide a gas stream at the second temperature (T2) for the mould wafer (15).

24. Apparatus according to one of Claims 12 - 23, a third clamping device (20), which can be heated to the second temperature (T2), being provided for setting the mould wafer (15) on the first clamping device (5; 50).

25. Apparatus according to one of claims 12-24, The first clamping device (5; 50) including a heating circuit which is arranged to heat the first clamping device (5; 50) to the second temperature (T2)

## Revendications

1. Procédé de traitement thermique de galettes semiconductrices moulées (15) comprenant les étapes suivantes :
- serrage d'une galette moulée (15) située à une première température (T1) sur un premier dispositif de serrage (5 ; 50) ; la première température (T1) se trouvant sous la température de durcissement (TH) de la matière synthétique de la galette moulée (15) ;
- chauffage de la galette moulée(15) serrée sur le premier dispositif de serrage (5 ; 50), à une seconde température (T2) supérieure à la première température (T1) et se trouvant au-dessus de la température de durcissement (TH) ;
- suppression du serrage du premier dispositif de serrage (5 ; 50) et transport essentiellement sans contact de la galette moulée (15) chauffée à la seconde température (T2) du premier dispositif de serrage (5 ; 50) à un second dispositif de serrage (9 ; 90) ;
- serrage de la galette moulée (15) chauffée sur le second dispositif de serrage (9 ; 90) ;
- refroidissement de la galette moulée (15) serrée sur le second dispositif de serrage (9 ; 90), à une troisième température (T4) inférieure à la première température (T1) et se trouvant en dessous de la température de durcissement (TH) ; et
- suppression du serrage par le second dispositif de serrage (9 ; 90).

2. Procédé selon la revendication 1, le transport sans contact de la galette moulée (15) chauffée étant exécuté au moyen d'un dispositif de transport à coussin de gaz (7).

3. Procédé selon la revendication 2, le premier dispositif de serrage (5 ; 50), le second dispositif de serrage (9 ; 90) et le dispositif de transport à coussin de gaz (7) formant une surface commune plane (0).

4. Procédé selon la revendication 1, le transport sans contact de la galette moulée (15) chauffée étant exécuté au moyen d'un dispositif de serrage de Bernoulli (20').

5. Procédé selon une des revendications 1 à 3, le premier dispositif de serrage (5 ; 50) présentant des buses de soufflage (5b) dirigées dans le sens de transport (TR), à l'aide desquelles le transport est initié.

6. Procédé selon la revendication 2, le premier dispositif de serrage (5 ; 50), le second dispositif de serrage (9 ; 90) et le dispositif de transport à coussin de gaz (7) étant basculés conjointement dans le sens de transport (TR) pour initier le transport.

7. Procédé selon l'une des revendications précédentes, la galette moulée (15) étant reliée, à la première température (T1), par une pellicule thermiquement détachable (16) avec un substrat porteur (17), et le substrat porteur (17) et la pellicule thermiquement détachable (16) étant retirés de la galette moulée (15) à la seconde température (T2).

8. Procédé selon la revendication 7, la galette moulée (15) étant disposée sur le premier dispositif de serrage (5 ; 50) au moyen d'un troisième dispositif de serrage (20) et le retrait du substrat porteur (17) étant exécuté par écartement après un détachement thermique de la pellicule (16) à la seconde température (T2) au moyen du troisième dispositif de serrage (20).

9. Procédé selon l'une des revendications précédentes, le serrage étant exécuté sur le premier dispositif de serrage (5 ; 50) et/ou sur le second dispositif de serrage (9 ; 90) par aspiration à l'aide de buses à vide (5a ; 9a).

10. Procédé selon l'une des revendications précédentes, l'atteinte d'une position de fin de course prédéterminée de la galette moulée (15) étant saisie sur le second dispositif de serrage (9 ; 90) par un dispositif de sonde (30) et le serrage de la galette moulée (15) chauffée étant déclenché sur le second dispositif de serrage (9 ; 90) par un signal de sortie correspondant (SIG) du dispositif de sonde (30).

11. Procédé selon l'une des revendications précédentes, la galette moulée (15) étant reliée avec une plaque de transport (14) et la galette moulée (15) étant serrée par l'intermédiaire de la plaque de transport (14) sur le premier dispositif de serrage (5 ; 50) et le second dispositif de serrage (9 ; 90) et la galette moulée (15) étant transportée par l'intermédiaire de la plaque de transport (14) du premier dispositif de serrage (5 ; 50) au second dispositif de serrage (9 ; 90).

12. Procédé de traitement thermique de galettes moulées (15) comprenant :
- un premier dispositif de serrage (5 ; 50) chauffant conçu pour serrer une galette moulée (15) se trouvant à une première température (T1),
la première température (T1) étant située en dessous de la température de durcissement de la matière plastique de la galette moulée (15), et étant conçu pour être chauffé, pour chauffer la galette moulée (15) serrée, à une seconde température (T2) se trouvant au-dessus de la température de durcissement (TH) ;
- un second dispositif de serrage (9 ; 90) réfrigérable, conçu pour serrer la galette moulée (15) chauffée, qui est conçu, pour refroidir la galette moulée (15) serrée, pour être amené à une troisième température (T4) étant inférieure à la seconde température (T2) et se trouvant en dessous de la température de durcissement (TH) ;
- un dispositif de transport (7 ; 20') conçu pour transporter la galette moulée (15) chauffée sans contact du premier dispositif de serrage (5 ; 50) au second dispositif de serrage (9 ; 90).

13. Dispositif selon la revendication 12, le dispositif de transport (7 ; 20) présentant un dispositif de coussin à gaz (7).

14. Dispositif selon la revendication 13, le premier dispositif de serrage (5 ; 50), le second dispositif de serrage (9 ; 90) et le dispositif de transport à coussin de gaz (7) formant une surface commune plane (0).

15. Dispositif selon la revendication 12, le dispositif de transport (7 ; 20) présentant un dispositif de serrage de Bernoulli (20').

16. Dispositif selon l'une des revendications 12 à 14, le premier dispositif de serrage (5 ; 50) présentant des buses de soufflage (5b) dirigées dans le sens de transport (TR).

17. Dispositif selon la revendication 14, le premier dispositif de serrage (5 ; 50), le second dispositif de serrage (9 ; 90) et le dispositif de transport à coussin de gaz (7) pouvant être basculés conjointement dans le sens de transport (TR) pour initier le transport.

18. Dispositif selon l'une des revendications 12 à 17, le premier dispositif de serrage (5 ; 50) et/ou le second dispositif de serrage (9 ; 90) présentant des buses à vide (5a ; 9a) destinées à aspirer la galette moulée (15).

19. Dispositif selon l'une des revendications 12 à 18, un dispositif de sonde (30) étant prévu pour saisir l'atteinte d'une position de fin de course prédéterminée de la galette moulée (15) sur le second dispositif de serrage (9 ; 90) et pour émettre un signal de sortie correspondant (SIG) pour démarrer le serrage du second dispositif de serrage (9 ; 90).

20. Dispositif selon l'une des revendications 12 à 19, la galette moulée (15) étant reliée avec une plaque de transport (14) et la galette moulée (15) pouvant être serrée par l'intermédiaire de la plaque de transport (14) sur le premier dispositif de serrage (5 ; 50) et le second dispositif de serrage (9 ; 90) et la galette moulée (15) pouvant être transportée par l'intermédiaire de la plaque de transport (14) du premier dispositif de serrage (5 ; 50) au second dispositif de serrage (9 ; 90).

21. Dispositif selon la revendication 19, le dispositif de sonde (30) présentant une sonde optique sans contact.

22. Dispositif selon l'une des revendications 12 à 21, le dispositif de chauffage à infrarouge (100) étant prévu au-dessus du dispositif de transport (7 ; 20') et du second dispositif de serrage (9 ; 90), dont la température (T3) se trouve au niveau de la seconde température (T2).

23. Dispositif selon la revendication 13, le dispositif de transport à coussin de gaz (7) étant agencé de telle sorte qu'il peut mettre à disposition un flux de gaz à la seconde température (T2) pour la galette moulée (15).

24. Dispositif selon l'une des revendications 12 à 23, le troisième dispositif de serrage (20) étant prévu pour disposer la galette moulée (15) sur le premier dispositif de serrage (5 ; 50), qui peut être chauffé à la seconde température (T2).

25. Dispositif selon l'une des revendications 12 à 24, le premier dispositif de serrage (5 ; 50) comprenant un circuit de chauffage conçu pour chauffer le premier dispositif de serrage (5 ; 50) à la seconde température (T2).
